# EUROPEAN PATENT APPLICATION

(11) **EP 4 203 618 A1**
(43) Date of publication of application: **28.06.2023**
(21) Application number: 21216261.4
(22) Date of filing: 21.12.2021
(51) Int. Cl.: H05B 45/12, H05B 45/50

(54) **LIGHTING SYSTEM**

(71) Applicant: Tridonic GmbH & Co. KG, 6851 Dornbirn (AT)
(72) Inventor: Walch, Patrick, 6850 Dornbirn (AT); Maldoner, Jakob, 6850 Dornbirn (AT)
(74) Representative: Rupp, Christian

(57) **Abstract**

The invention relates to a lighting system, comprising: one or more converters for driving LED lighting means, one or more LED based lighting means driven by the one or more converters; a backend system unit for the lighting system, and a lighting sensor arranged for detecting light emitted by the one or more lighting means and arranged for issuing a signal to said backend system unit, the backend system unit being configured to analyze the signal supplied by the sensor in order to detect whether one or more characteristic (s) of the light emitted by the one or more lighting means is/are within preset ranges, and to preferably issue a signal in case one or more characteristics are outside its/their respective characteristic(s) .

## Description

### TECHNICAL FIELD OF THE INVENTION

The invention is in the field of detection of a non-optimal operation or faulty operation of a converter, in particular, for LED-based lighting means.

### BACKGROUND OF THE INVENTION

Predictive maintenance is playing an increasingly important role regarding customer satisfaction, security, data processing, and maintenance.

Electrolytic capacitors (ELCAPS) play an important role for the function of many electronic devices. The increasing demand for an enhanced efficiency, the growing utilization of renewable energy and the continuous growth of electronic content in, e.g., automotive applications have driven the usage of these components.

In many applications, the lifetime of electronic devices is directly related to the lifetime of ELCAPS inside. In order to ensure a reliable operation of electronic devices for a defined period, the knowledge of the properties of the ELCAPS is desirable.

Thus, it is an objective to provide for an improved predictive lighting system and method on how an upcoming failure of electronic devices, in particular LED luminaires or LED-based lighting means, can be avoided.

### SUMMARY OF THE INVENTION

The object of the present invention is achieved by the solution provided in the enclosed independent claims. Advantageous implementations of the present invention are further defined in the dependent claims.

According to a first aspect of the invention, a lighting system is provided. The lighting system comprises one or more converters for driving LED lighting means, one or more LED based lighting means driven by the one or more converters, a backend system unit for the lighting system, and a lighting sensor arranged for detecting light emitted by the one or more lighting means, and arranged for issuing a signal to said backend system unit, the backend system unit being configured to analyze the signal supplied by the sensor in order to detect whether one or more characteristic (s) of the light emitted by the one or more lighting means is/are within preset ranges, and to preferably issue a signal in case one or more characteristics are outside its/their respective characteristic(s).

This provides the advantage that a future failure of the one or more converters can easily be predicted.

In a preferred embodiment, the backend system unit is connected to the one or more converters via a wired or wireless control channel.

In a preferred embodiment, the backend system unit is configured to modify an operation of the one or more converters, if the characteristic(s) is/are outside the preset ranges.

This provides the advantage that a failure of the one or more converters can be avoided.

In a preferred embodiment, the lighting system comprises an electrolytic capacitor, and the backend system unit is configured to detect a low-frequency ripple produced by a deterioration of the electrolytic capacitor.

This provides the advantage that the lifetime of the electrolytic capacitor reflects the lifetime of the one or more converters. Therefore, by detecting a deterioration of the electrolytic capacitor, a deterioration of the one or more converters can be detected as well.

In a preferred embodiment, the one or more converters comprise a communication interface, e.g., a DALI interface.

This provides the advantage that a well-known communication interface, such as a DALI interface, can be used.

In a preferred embodiment, the lighting system further comprises a RF communication interface associated to the backend system unit.

This provides the advantage that a well-known communication interface, such as a RF interface, can be used.

In a preferred embodiment, the lighting sensor comprises a camera sensor.

This provides the advantage that the light emitted by the one or more lighting means can easily be detected.

In a preferred embodiment, the camera sensor is arranged to detect light of the one or more lighting means driven by the one or more converters.

This provides the advantage that the light emitted by the one or more lighting means can easily be detected.

According to a second aspect, the invention relates to a luminaire comprising a lighting system according to the first aspect and any one of the implementation forms thereof.

The luminaire according to the second aspect provides the same advantages as the lighting system according to the first aspect.

According to a third aspect, the invention relates to a method for detecting a ripple in a light output of one or more LED based lighting means driven by one or more converters, the ripple being produced by degradation effects of electronic components of the one or more converters. The method comprises the steps of: sensing the light output of the one or more LED based lighting means; and analyzing, in a backend system unit, whether a ripple amplitude in the sensed light output is higher than a threshold value.

The method according to the third aspect provides the same advantages as the lighting system according to the first aspect.

In a preferred embodiment, the method further comprises the step of: modifying, by the backend system unit, the light output for a given nominal light output value of the one or more converters.

In a preferred embodiment, the method further comprises the step of sending a signal to the one or more converters, by the backend system unit, if the ripple amplitude in the sensed light output is higher than the threshold value.

In a preferred embodiment, the electronic components of the one or more converters comprise an electrolytic capacitor.

In a preferred embodiment, the method further comprises detecting a low-frequency ripple produced by a deterioration of the electrolytic capacitor.

According to a fourth aspect, the invention relates to the use of a sensor for detecting low frequency ripple, the ripple being produced by degradation effects of electronic components of one or more converters for driving LED lighting means.

### BRIEF DESCRIPTION OF THE DRAWINGS

The invention will be explained in the followings together with the figures.
- Fig. 1: shows a schematic representation of a lighting system comprising one or more converters for driving LED lighting means according to an embodiment; and
- Fig. 2: shows a schematic representation of a method for detecting a ripple in a light output of one or more LED based lighting means driven by one or more converters according to an embodiment.

### DETAILED DESCRIPTION OF THE PREFERRED EMBODIMENTS

Aspects of the present invention are described herein in the context of a lighting system.

The present invention is described more fully hereinafter with reference to the accompanying drawings, in which various aspects of the present invention are shown. This invention however may be embodied in many different forms and should not be construed as limited to the various aspects of the present invention presented through this disclosure. Rather, these aspects are provided so that this disclosure will be thorough and complete, and will fully convey the scope of the present invention to those skilled in the art. The various aspects of the present invention illustrated in the drawings may not be drawn to scale. Rather, the dimensions of the various features may be expanded or reduced for clarity. In addition, some of the drawings may be simplified for clarity. Thus, the drawings may not depict all of the components of a given apparatus.

It is further understood that the aspect of the present invention might contain integrated circuits that are readily manufacturable using conventional semiconductor technologies, such as complementary metal-oxide semiconductor technology, short "CMOS". In addition, the aspects of the present invention may be implemented with other manufacturing processes for making optical as well as electrical devices. Reference will now be made in detail to implementations of the exemplary aspects as illustrated in the accompanying drawings. The same references signs will be used throughout the drawings and the following detailed descriptions to refer to the same or like parts.

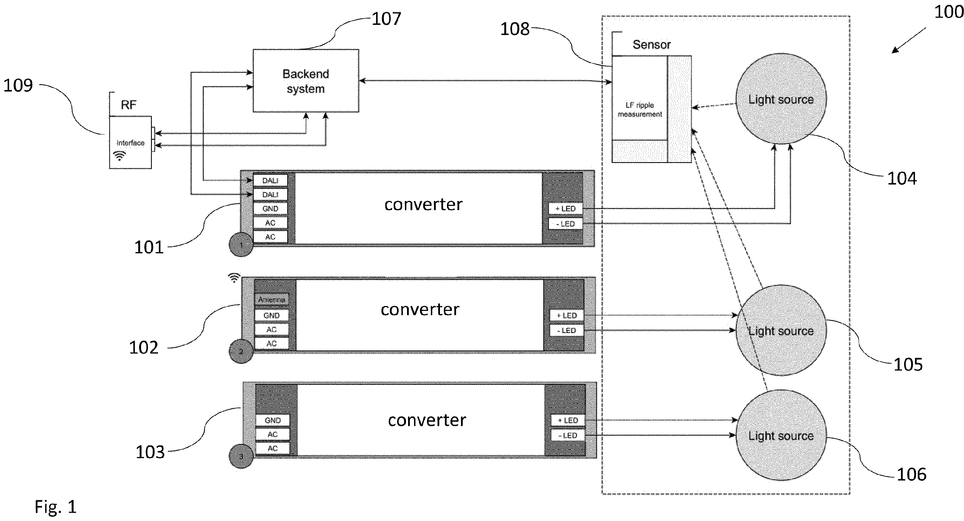

Fig. 1 shows a schematic representation of a lighting system 100 comprising one or more converters 101, 102, 103 for driving lighting means according to an embodiment.

The lighting system 100 comprises:
- one or more converters 101, 102, 103 for driving LED lighting means,
- one or more LED based lighting means 104, 105, 106 driven by the one or more converters 101, 102, 103;
- a backend system unit 107 for the lighting system 100, and
- a lighting sensor 108 arranged for detecting light emitted by the one or more lighting means 104, 105, 106 and arranged for issuing a signal to said backend system unit 107, the backend system unit 107 being configured to analyze the signal supplied by the sensor 108 in order to detect whether one or more characteristic(s) of the light emitted by the one or more lighting means 104, 105, 106 is/are within preset ranges, and to preferably issue a signal in case one or more characteristics are outside its/their respective characteristic(s).

For example, the lighting sensor 108 can be configured to detect the light output from the one or more LED light sources 104, 105, 106, and either carries out an evaluation of the light output itself, for example with regard to a possible ripple, and sends a signal to the backend system unit 107, or reports a signal reflecting the light level to the backend system unit 107. In any case, this direct light power detection makes it possible to directly detect the quality of the light generated by the one or more converters 101, 102, 103 and, for example, to evaluate it for a ripple level that may possibly increase due to aging of the electronic components of the one or more converters 101, 102, 103.

For example, the backend system unit 107 can be configured to send an error or maintenance message, if the detected ripple has exceeded a predetermined threshold value.

The aging-related increase in the ripple may be caused by aging of a storage capacitor (electrolytic capacitor) at the output of the control gear.

If, for example, the one or more converters 101, 102, 103 do not have a communication interface (e.g. DALI), based on the values recorded by the lighting sensor 108, the operating status of the LED can still be recorded via the backend system unit 108 and, thus, responded.

If, for example, the one or more converters 101, 102, 103 have a communication interface (e.g., DALI), there can be a direct connection to the backend system unit 107. The lighting sensor 107 can carry out evaluations in addition to the existing diagnostic data of the one or more converters 101, 102, 103.

Alternatively or additionally, the one or more converters 101, 102, 103 can comprise a wireless communication interface and a RF interface 109 can be assigned to the backend system unit 107.

The lighting sensor 107 can be configured to detect the light output in a spatially resolved manner with respect to the plurality of light sources 104, 105, 106 assigned to the different converters 101, 102, 103. For example, the lighting sensor 108 can be implemented by a camera, so that the lighting sensor, then, can be configured to send either the light power signal from different light sources 104, 105, 106, or the evaluation of the ripple, or the evaluation of an exceeding of predetermined threshold values by the ripple, to the backend system unit 107.

Furthermore, if there are signs of aging (e.g., reduction in the LED light output), the current LED light level can be corrected back to the initial value (current level adjustment or voltage adjustment for "constant voltage" devices). This advantageously ensures a homogeneous light level with different light sources (aging).

Furthermore, the backend system unit 107 can send control signals to the one or more converters 101, 102, 103, if an excessive low-frequency (LF) ripple was detected in their light output. The operation of the assigned converters 101, 102, 103 can, thus, be changed in such a way that, for example, the effect of the ripple in the overall lighting system is reduced, for example, by dimming or changing the operating mode of the one or more converters 101, 102, 103.

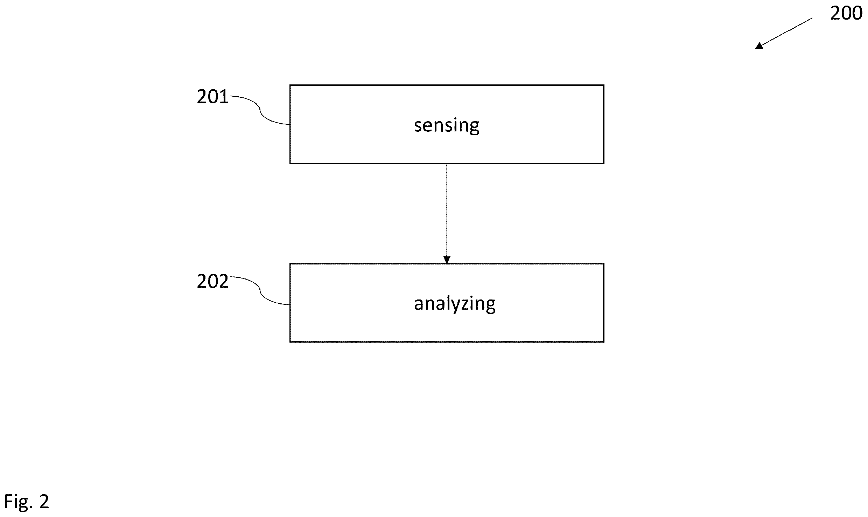

Fig. 2 shows a schematic representation of a method 200 for detecting a ripple in a light output of one or more LED based lighting means 104, 105, 106 driven by one or more converters 101, 102, 103, the ripple being produced by degradation effects of electronic components of the one or more converters 101, 102,103, according to an embodiment.

The method comprises the steps of:
- sensing 201 the light output of the LED based lighting means 104, 105, 106; and
- analyzing 202, in a backend system unit 107, whether a ripple amplitude in the sensed light output is higher than a threshold value.

All features of all embodiments described, shown and/or claimed herein can be combined with each other.

While various embodiments of the present invention have been described above, it should be understood that they have been presented by way of example only and not limitation. Numerous changes to the disclosed embodiments can be made in accordance with the disclosure herein without departing from the spirit of scope of the invention. Thus, the breadth and scope of the present invention should not be limited by any of the above-described embodiments. Rather, the scope of the invention should be defined in accordance with the following claims and their equivalence.

Although the invention has been illustrated and described with respect to one or more implementations, equivalent alternations and modifications will occur to those skilled in the art upon the reading of the understanding of the specification and the annexed drawings. In addition, while a particular feature of the invention may have been disclosed with respect to only of the several implementations, such features may be combined with one or more other features of the other implementations as may be desired and advantage for any given or particular application.

## Claims

1. Lighting system (100), comprising:
- one or more converters (101, 102, 103) for driving LED lighting means,
- one or more LED based lighting means (104, 105, 106) driven by the one or more converters (101, 102, 103);
- a backend system unit (107) for the lighting system (100), and
- a lighting sensor (108) arranged for detecting light emitted by the one or more lighting means (104, 105, 106) and arranged for issuing a signal to said backend system unit (107), the backend system unit (107) being configured to analyze the signal supplied by the sensor (108) in order to detect whether one or more characteristic(s) of the light emitted by the one or more lighting means (104, 105, 106) is/are within preset ranges, and to preferably issue a signal in case one or more characteristics are outside its/their respective characteristic(s).

2. The lighting system (100) of claim 1, wherein the backend system unit (107) is connected to the one or more converters (101, 102, 103) via a wired or wireless control channel.

3. The lighting system (100) of claim 1 or 2, wherein the backend system unit (107) is configured to modify an operation of the one or more converters (101, 102, 103), if the characteristic(s) is/are outside the preset ranges.

4. The lighting system (101) of any one of the preceding claims, wherein the lighting system (100) comprises an electrolytic capacitor and the backend system unit (107) is configured to detect a low-frequency ripple produced by a deterioration of the electrolytic capacitor.

5. The lighting system (100) of any one of the preceding claims, wherein the one or more converters (101, 102, 103) comprise a communication interface, e.g., a DALI interface.

6. The lighting system (100) of any one of the preceding claims, wherein the lighting system (100) further comprises a RF communication (109) interface associated to the backend system unit (107).

7. The lighting system (100) of any one of the preceding claims, wherein the lighting sensor (108) comprises a camera.

8. The lighting system (100) of claim 7, wherein the camera sensor is arranged to detect light of one or more lighting means (104, 105, 106) driven by the one or more converters (101, 102, 103).

9. Luminaire comprising a lighting system (100) according to any one of the claims 1 to 8.

10. Method (200) for detecting a ripple in a light output of one or more LED based lighting means (104, 105, 106) driven by one or more converters (101, 102,103), the ripple being produced by degradation effects of electronic components of the one or more converters (101, 102,103), comprising:
- sensing (201) the light output of the one or more LED based lighting means (104, 105, 106); and
- analyzing (202), in a backend system unit (107), whether a ripple amplitude in the sensed light output is higher than a threshold value.

11. The method (200) of claim 10, further comprising the step of:
- modifying, by the backend system unit (107), the light output for a given nominal light output value of the one or more converters (101, 102, 103).

12. The method (200) of claim 10 or 11, wherein the method (200) further comprises the step of:
- sending a signal to the one or more converters (101, 102, 103), by the backend system unit (107), if the ripple amplitude in the sensed light output is higher than the threshold value.

13. The method (200) of any one of the preceding claims 10 to 12, wherein the electronic components of the one or more converters (101, 102, 103) comprise an electrolytic capacitor.

14. The method (200) of claim 13, wherein the method (200) further comprises:
- detecting a low-frequency ripple produced by a deterioration of the electrolytic capacitor.

15. Use of a sensor for detecting low frequency ripple, the ripple being produced by degradation effects of electronic components of one or more converters (101, 102,103) for driving one or more LED lighting means (104, 105, 106).
